# EUROPÄISCHE PATENTANMELDUNG

(11) **EP 2 492 085 A1**
(43) Veröffentlichungstag der Anmeldung: **29.08.2012**
(21) Anmeldenummer: 12155363.0
(22) Anmeldetag: 14.02.2012
(51) Int. Cl.: B29C 67/00

(54) **Verfahren und Vorrichtung zum ortsaufgelösten Einbringen eines Intensitätsmusters aus elektromagnetischer Strahlung in eine photosensitive Substanz sowie Anwendungen hiervon**

(30) Priorität: 25.02.2011 DE 102011012484
(71) Anmelder: Nanoscribe GmbH, 76344 Eggenstein-Leopoldshafen (DE)
(72) Erfinder: Thiel, Dr. Michael, 76137 Karlsruhe (DE); Fischer, Dr. Holger, 76189 Karlsruhe (DE)
(74) Vertreter: Lemcke, Brommer & Partner

(57) **Zusammenfassung**

Die Erfindung betrifft ein Verfahren zum ortsaufgelösten Einbringen eines Intensitätsmusters aus elektromagnetischer Strahlung mittels eines optischen Abbildungssystems in eine photosensitive Substanz 2 mit durch Photoneneinstrahlung veränderbaren Eigenschaften. Diese Eigenschaften umfassen einen ersten, flüssigen und mindestens einen zweiten Zustand, wobei die elektromagnetische Strahlung 4 über das optische Abbildungssystem 3 in die photosensitive Substanz 2 geleitet und dort auf vorbestimmte Ortskoordinaten abgebildet wird, um an diesen Ortskoordinaten oder in diese umgebenden Bereichen eine Veränderung der Substanzeigenschaften zu erzeugen. Hierzu wird eine Oberfläche 6 einer Objektivlinse des optischen Abbildungssystems 3, durch die die elektromagnetische Strahlung 4 aus diesem austritt, in die flüssige photosensitive Substanz 2 eingetaucht.

Gegenstand der vorliegenden Erfindung sind außerdem eine Vorrichtung zur Durchführung dieses Verfahrens sowie dessen Anwendung beim Erzeugen von mikro- oder nanoskaliger Strukturen.

## Beschreibung

Die Erfindung betrifft ein Verfahren zum ortsaufgelösten Einbringen eines Intensitätsmusters aus elektromagnetischer Strahlung in eine photosensitive Substanz mit durch Photoneneinstrahlung veränderbaren Eigenschaften nach dem Oberbegriff des Anspruchs 1 sowie eine Vorrichtung zum Durchführen eines solchen Verfahrens nach dem Oberbegriff des Anspruchs 12. Die vorliegende Erfindung kann insbesondere beim Beschreiben, Löschen und Wiederbeschreiben eines optischen Datenspeichers sowie beim Ausbilden mikro- und nanoska-liger Strukturen Anwendung finden. Auch diese Anwendungen bzw. Verwendungen sind Gegenstand der vorliegenden Erfindung.

Die im Rahmen der vorliegenden Erfindung verwendete photosensitive Substanz besitzt als Ausgangszustand einen ersten, flüssigen Zustand und kann ihre Eigenschaften durch Photoneneinstrahlung in mindestens einen zweiten Zustand verändern. Die Veränderung dieser Eigenschaften erfolgt dadurch, dass elektromagnetische Strahlung mittels eines optischen Abbildungssystems in die Substanz geleitet und dort auf vorbestimmte Ortskoordinaten abgebildet wird, um an diesen Ortskoordinaten bzw. in Bereichen, die diese Ortskoordinaten umgeben, eine Veränderung der Substanzeigenschaften zu erzeugen. Bei der elektromagnetischen Strahlung kann es sich insbesondere, ohne Einschränkung der Allgemeinheit, um einen kollimierten Laserstrahl handeln, der durch das optische Abbildungssystem auf ein beugungsbegrenztes Volumen abgebildet wird, also fokussiert wird. Die Veränderung der Substanzeigenschaften kann dauerhaft sein und beispielsweise in einer Veränderung des flüssigen in einen festen Zustand bestehen; für Anwendungen wie die Speicherung von Daten kann die Veränderung der Substanzeigenschaften jedoch auch nur vorübergehend sein und beispielsweise durch eine thermische Behandlung der Substanz beseitigt werden oder sich von selbst zurückbilden. Auch eine dauerhafte Veränderung kann im Übrigen reversibel oder nicht-reversibel sein.

Der erste, flüssige Zustand der verwendeten photosensitiven Substanz ist im Rahmen der vorliegenden Erfindung nicht nur als flüssiger Aggregatzustand im eigentlichen Sinne zu verstehen, also als der Zustand eines Stoffs, in dem dieser einer Formänderung so gut wie keinen bzw. beim dickflüssigen Fluid nur einen geringen, einer Volumenänderung hingegen einen recht großen Widerstand entgegensetzt, sondern die photosensitive Substanz kann in ihrem ersten, flüssigen Zustand auch als Paste, also als Feststoff-Flüssigkeitsgemisch oder Suspension mit einem hohen Gehalt an Feststoffen vorliegen, die gegebenenfalls gar nicht mehr fließfähig, sondern streichfest ist.

Die elektromagnetische Strahlung, die im Rahmen der vorliegenden Erfindung eingesetzt wird, ist im Normalfall Licht im sichtbaren oder infraroten Spektrum. Wenn im folgenden daher zur einfacheren Darstellung bzw. Formulierung von "Lichtstrahl", "Lichteinstrahlung" und "Belichtung" gesprochen wird, ist dies nur beispielhaft zu verstehen und schließt nicht aus, dass im Rahmen der vorliegenden Erfindung gegebenenfalls auch elektromagnetische Strahlung mit anderen Wellenlängen verwendet wird.

Das ortsaufgelöste Einbringen der elektromagnetischen Strahlung erfolgt im Rahmen der vorliegenden Erfindung durch eine optische Abbildung, wodurch die Strahlung als Intensitätsmuster abgebildet, insbesondere fokussiert wird. Wenn im folgenden von "Fokussieren" gesprochen wird, steht dies stellvertretend für das Einbringen von optisch abgebildeten Intensitätsmustern der elektromagnetischen Strahlung in die photosensitive Substanz; denn im Rahmen der vorliegenden Erfindung können auch Abbildungen von anderen Intensitätsmustern in eine Bildebene innerhalb der photosensitiven Substanz zum Einsatz kommen.

Ein Verfahren und eine Vorrichtung der vorliegenden Art werden in der Regel zum ortsaufgelösten Belichten (im Folgenden auch: Schreiben) von ein-, zwei- oder dreidimensionalen Strukturen in der photosensitiven Substanz verwendet, um insbesondere Daten mehrdimensional zu speichern oder mehrdimensionale Gegenstände bzw. Strukturen und Masken im Nanometer- und Mikrometerbereich zu erzeugen.

Im Bereich der Stereolithographie zum Erzeugen von Strukturen im Makrobereich ist beispielsweise in der DE 101 11 422 A1 vorgeschlagen worden, einen Lichtstrahl in eine flüssige photosensitive Substanz einzuleiten und dort zu fokussieren, wo die Substanz von ihrem flüssigen in einen festen Zustand übergehen soll. Diese Änderung der Substanzeigenschaften findet im Idealfall genau im Bereich des Fokus statt. Dies kann sowohl durch einen linearen, als auch durch einen nichtlinearen Effekt erreicht werden: Entweder reagiert die Substanz linear, besitzt aber einen Intensitätsgrenzwert, unterhalb dessen eine Veränderung durch Lichteinstrahlung nicht mehr oder nicht ausreichend stattfindet, oder die Substanz reagiert nichtlinear, was insbesondere beim Verfahren der Zwei- oder Mehrphotonenpolymerisation der Fall ist. Im letztgenannten Verfahren ist die Wahrscheinlichkeit zur Eigenschaftsänderung der Substanz im Fokus durch die dort erhöhte Intensität im Vergleich zur Umgebung gesteigert.

Das exakte, ortsaufgelöste Einbringen eines fokussierten Lichtstrahls in eine photosensitive Substanz eignet sich insbesondere dann zur Herstellung einer dreidimensionalen Struktur, wenn die Veränderung der Substanz relativ genau und ausschließlich im Fokus hervorgerufen wird. Denn durch geeignete Abbildungssysteme, beispielsweise Piezobühnen zur Bewegung des Substrats oder strahlablenkende Vorrichtungen, wie Galvanospiegel, Mikrospiegelaktoren, räumliche Modulatoren für Licht oder akusto-optische Deflektoren, kann der Fokus einen recht großen, dreidimensional ausgedehnten Schreibbereich in der photosensitiven Substanz scannen. Dies ist eher nicht für stereolithographische Verfahren, wie sie aus der DE 101 11 422 A1 bekannt sind, interessant, sondern insbesondere für die Herstellung von nano- und mikroskaligen Strukturen, Lichtwellenleitern oder für räumlich verteilt beschreibbare optische Datenspeicher, bei denen ein Hauptaugenmerk auf der hohen Auflösung der Strukturen liegt und deshalb Objektive in Verbindung mit Immersionsmitteln verwendet werden müssen. Um hierbei das von der Wellenlänge des verwendeten Lichts abhängige Beugungslimit, die Abbe'sche Grenze, zu überwinden, ist in der EP 1 616 344 B1 vorgeschlagen worden, die ortsaufgelöste Veränderung der Substanzeigenschaften mit einem beugungslimitierten Signal anzuregen und diese Veränderung gleichzeitig mit einem versetzten beugungslimitierten Signal lokal wieder abzuregen.

Bei einer Veränderung der Ortskoordinaten entlang der optischen Achse des verwendeten optischen Abbildungssystems ergibt sich jedoch, wie überall auf dem Gebiet der abbildenden Optik, das Problem der Abbildungsfehler oder Aberrationen, die mit zunehmender Schreibtiefe, also mit zunehmendem Anteil von Material im optischen Pfad mit nicht optimal abgestimmtem Brechungsindex, zunehmen. Im Stand der Technik können daher nur dreidimensionale Strukturen mit sehr begrenzter Höhe erzeugt werden.

Auf dem Gebiet der Zwei- und Mehrphotonenabsorbtionslithographie ist bereits ein Verfahren bekannt, das das Problem der Abbildungsfehler durch Ausnutzen einer Vorkompensation statisch auszugleichen versucht. In der Publikation APPLIED OPTICS Volume 27, Nummer 26 (1998) ist ein Verfahren beschrieben, welches zwei entlang der optischen Achse bewegbare Tubuslinsen verwendet. Durch relative Auslenkung der Tubuslinsen werden Aberrationen aller Ordnungen erzeugt, die so gewählt werden können, dass sie gerade die Fehler des nachfolgenden optischen Systems teilweise vorkompensieren. Dieses Verfahren erlaubt nur die teilweise Kompensation der Aberrationen und ist technisch äußerst anspruchsvoll, weil zusätzliche fehlerbehaftete Komponenten verwendet und bewegt werden müssen. Zudem muss für jede Belichtungsebene entlang der optischen Achse eine neue relative Position der Tubuslinsen eingestellt werden. Des Weiteren verschiebt sich aufgrund der Tubuslinsen die Abbildung entlang der optischen Achse, so dass die kompensierte Abbildung gezerrt oder gestaucht wird. Unter Umständen kann sich in der kompensierten Abbildung zudem die eingestrahlte Belichtungsdosis ändern, was sich nachteilig auf die resultierenden Strukturen auswirkt.

Ausgehend von diesem Stand der Technik liegt der vorliegenden Erfindung die Aufgabe zugrunde, bei einem Verfahren und einer Vorrichtung der vorliegenden Art Abbildungsfehler weitgehend zu vermeiden oder im Wesentlichen entlang der optischen Achse des Abbildungssystems konstant zu halten.

Gelöst ist diese Aufgabe durch ein Verfahren mit den Merkmalen des Anspruchs 1 sowie durch eine Vorrichtung mit den Merkmalen des Anspruchs 12.

Vorteilhafte Weiterbildungen des erfindungsgemäßen Verfahrens finden sich in den Ansprüchen 2 bis 9; bevorzugte Ausgestaltungen der erfindungsgemäßen Vorrichtung sind in den Ansprüchen 13 bis 16 niedergelegt. Bevorzugte Anwendungen des erfindungsgemäßen Verfahrens finden sich in den Ansprüchen 10 und 11; eine bevorzugte Verwendung der erfindungsgemäßen Vorrichtung ist Gegenstand des Anspruchs 17.

Erfindungsgemäß wird die gegebene Aufgabe dadurch gelöst, dass das Objektiv des optischen Abbildungssystems bzw. eine Oberfläche einer Objektivlinse, durch die die elektromagnetische Strahlung, insbesondere ein Lichtstrahl, aus dem optischen Abbildungssystem austritt, in die flüssige photosensitive Substanz eingetaucht wird, in der die Veränderung der Substanzeigenschaften erzeugt werden soll. Die photosensitive Substanz fungiert demnach als Immersionssystem, so dass durch Verwenden von geeigneten Immersionsobjektiven die Abbildungsfehler nahezu oder gar vollständig eliminiert werden können. Selbst bei nicht ideal angepassten Brechungsindizes von Objektivlinse und photosensitiver Substanz führt die Erfindung zu sehr viel besseren Ergebnissen als bisher, denn auch dann sind die Aberrationen unabhängig von der Schreibtiefe konstant und die Abbildung im gesamten Schreibbereich identisch.

Ein Hauptgrund für diese erfindungsgemäßen Effekte besteht darin, dass die im Stand der Technik stets vorhandene(n) Grenzfläche(n) zwischen der photosensitiven Substanz und dem Objektiv des optischen Abbildungssystems im Wesentlichen entfällt (entfallen). Denn eine solche Grenzfläche (solche Grenzflächen) führt (führen) grundsätzlich zu Abbildungsfehlern.

Mit dem erfindungsgemäßen Verfahren werden also Abweichungen von einer idealen optischen Abbildung vermieden, indem die photosensitive Substanz gleichzeitig als Immersionsmittel dient, wobei ein Signal, also der Fokus oder ein sonstiges Intensitätsmuster der über das optische Abbildungssystem eingestrahlten elektromagnetischen Strahlung, wie beispielsweise eines Lichtstrahls, so auf einen Schreibbereich innerhalb der photosensitiven Substanz abgebildet wird, dass der Abstand zwischen der Objektivlinse und den Bildebenen der Signale im Schreibbereich einen konstanten Wert annimmt. Aberrationen aufgrund einer Brechungsindexfehlanpassung des optischen Systems bleiben entlang der optischen Achse konstant (und sind im Idealfall konstant Null), und die photosensitive Substanz kann im gesamten Schreibbereich mit identischen Foki bzw. Intensitätsmustern belichtet werden.

Ein weiterer, großer Vorteil der vorliegenden Erfindung besteht im Übrigen darin, dass die Ausdehnung der abbildbaren Ortskoordinaten in Richtung der optischen Achse des Abbildungssystems nicht mehr durch den Arbeitsabstand des Objektivs begrenzt ist. Denn das Objektiv taucht erfindungsgemäß beim Abbilden, insbesondere Fokussieren des Lichtstrahls auf die vorbestimmten Ortskoordinaten direkt in die photosensitive Substanz ein. Es können damit dreidimensionale Strukturen in die photosensitive Substanz geschrieben werden, deren Ausdehnung in Richtung der optischen Achse sehr viel größer ist und die somit sehr viel höher als die im Stand der Technik herstellbaren Strukturen sind, und zwar unter potentieller Beibehaltung höchster räumlicher Auflösung..

Das erfindungsgemäße Verfahren und die entsprechende Vorrichtung werden bevorzugt dazu benutzt, ein-, zwei- und/oder dreidimensionale Strukturen in einem Schreibbereich innerhalb der photosensitiven Substanz zu erzeugen.

In einer bevorzugten Variante des neuen Verfahrens besteht das Schreibsignal bzw. bestehen die Schreibsignale (mehrere Signale können zum Beispiel im Falle der oben anhand der DE 101 11 422 A1 beschriebenen STED Lithographie benötigt werden) aus Strahlung aus dem sichtbaren oder nahinfraroten elektromagnetischen Spektrum. Die Lichtquelle kann beispielsweise ein gepulster Laser oder ein Dauerstrichlaser sein. Ebenso können aber auch elektromagnetische Strahlen aus dem UV-Bereich oder mittel- oder ferninfraroten Bereich gewählt werden. Zudem kann der Belichtungsmechanismus beispielsweise (photo-) chemisch und/oder thermisch sein.

Mit der vorliegenden Erfindung kann ein optisches System dazu verwendet werden, mit konstanten Aberrationen oder ohne Aberrationen optische Datenspeicher mit besonders wenigen Abbildungsfehlern herzustellen. Durch Auswahl einer geeigneten photosensitiven Substanz kann ein solcher optischer Datenspeicher beschrieben, gelöscht und wiederbeschrieben werden.

Ebenso können Mikro- und Nanostrukturen mit ansonsten unerreichbarer Präzision über den gesamten Schreibbereich innerhalb einer photosensitiven Substanz hergestellt werden.

Durch einen schichtweisen Aufbau der in der photosensitiven Substanz zu erzeugenden ein-, zwei- und/oder dreidimensionalen Struktur kann vermieden werden, durch bereits vorstrukturiertes Material zu belichten bzw. zu schreiben. Denn in aller Regel ändert sich der Brechungsindex der photosensitiven Substanz, wenn sich diese aufgrund der Photoneneinstrahlung verändert. Dies kann zu weiteren Abbildungsfehlern führen, wenn der Lichtstrahl durch verändertes Material hindurch in die photosensitive Substanz fokussiert bzw. abgebildet wird.

Vorzugsweise wird die flüssige photosensitive Substanz auf einen als Substrat verwendeten Festkörper, beispielsweise eine Glasplatte oder einen sonstigen, beliebig geformten, gegebenenfalls auch opaken Körper, aufgebracht und dann das optische Abbildungssystem in die flüssige photosensitive Substanz eingetaucht. Das Substrat befindet sich damit nicht zwischen der photosensitiven Substanz und dem optischen Abbildungssystem, so dass insofern weitere Abbildungsfehler durch Grenzflächen vermieden werden und die Höhe der zu schreibenden Strukturen nicht durch den Arbeitsabstand des Objektivs des Abbildungssystems begrenzt wird.

Nach einer Weiterbildung dieser Variante der Erfindung wird ein transparenter, scheiben- oder plattenförmiger Festkörper als Substrat verwendet, der beidseitig eine flüssige photosensitive Substanz trägt. Auf der dem optischen Abbildungssystem zugewandten Seite des Substrats dient die photosensitive Substanz dann erfindungsgemäß als Immersionsmittel, wobei der Lichtstrahl nicht nur in diese gleichzeitig als Immersionsmittel fungierende photosensitive Substanz fokussiert werden kann, sondern bedarfsweise auch durch diese Substanz und das Substrat hindurch in die auf der abgewandten Seite auf das Substrat aufgebrachte photosensitive Substanz. Die Ausrichtung von Strukturen auf beiden Substratseiten ist erfindungsgemäß sehr viel genauer möglich als im bisherigen Stand der Technik, da in einem Schritt direkt auf beiden Substratseiten strukturiert werden kann. Das Drehen und Ausrichten des Substrates wie nach Stand der Technik erforderlich entfällt.

Als Strahlungsquelle für die elektromagnetische Strahlung bzw. als Lichtquelle wird für die vorliegende Erfindung vorzugsweise ein Laser, insbesondere ein Dauerstrichlaser oder gepulster Laser im elektromagnetischen Spektrum von UV, sichtbarem Licht oder nahinfrarot verwendet. Die flüssige photosensitive Substanz kann im Rahmen der vorliegenden Erfindung durch Photoneneinstrahlung auf physikalischem, thermischem und/oder chemischem Wege lokal verändert werden.

Die Veränderung der Substanzeigenschaften der photosensitiven Substanz können, wie an sich im Stand der Technik bekannt, durch einen Einphotonenprozess oder einen Mehrphotonenprozess initiiert und/oder abgeregt werden.

Wie bereits erwähnt, können die erfindungsgemäße Vorrichtung und das Verfahren insbesondere und vorteilhaft zum Beschreiben und/oder Löschen von Datenspeichern sowie zum Erzeugen mikro- oder nanoskaliger Strukturen verwendet werden. In letzterem Fall können die durch Photonenabsorbtion veränderten Punkte oder Bereiche der photosensitiven Substanz anschließend durch einen selektiven Entwicklungsprozess freigelegt oder auch entfernt werden.

Die vorliegende Erfindung basiert auf der Erkenntnis, dass das in die photosensitive Substanz abgebildete Intensitätsmuster der elektromagnetischen Strahlung, insbesondere ein Lichtstrahl-Fokus, mit zunehmender Schreibtiefe, also zunehmender Eindringtiefe in die brechzahlfehlangepasste photosensitive Substanz entlang der optischen Achse des Abbildungssystems Abbildungsfehler aufsammelt und damit eine genaue Ortsauflösung nicht mehr zulässt. Die Abbildungsfehler sind umso stärker, je unterschiedlicher die Brechungsindizes zwischen der photosensitiven Substanz und der Luft bzw. einem Substrat sind, wenn durch ein solches hindurch eingestrahlt wird. Die Abbildungsfehler werden erfindungsgemäß nicht unbedingt beseitigt, sondern innerhalb eines Schreibbereichs entlang der optischen Achse des Abbildungssystems lediglich konstant oder zumindest im Wesentlichen konstant gehalten, so dass eine hochgenaue Ortsauflösung innerhalb der photosensitiven Substanz erzielt werden kann.

Ein Ausführungsbeispiel für eine erfindungsgemäße Vorrichtung sowie Versuchsergebnisse für ein erfindungsgemäß durchgeführtes Verfahren werden im Folgenden anhand der beigefügten Zeichnungen näher beschrieben und erläutert. Es zeigen:
- Figur 1: eine schematische Darstellung einer Anordnung von erfindungswesentlichen Vorrichtungsteilen;
- Figur 2: eine Abbildung einer mit dem erfindungsgemäßen Verfahren hergestellten dreidimensionalen Mikrostruktur;
- Figur 3: eine Abbildung einer nach dem Stand der Technik hergestellten dreidimensionalen Mikrostruktur nach derselben Vorlage wie Figur 3;
- Figur 4: eine weitere Abbildung einer mit dem erfindungsgemäßen Verfahren hergestellten Mikrostruktur;
- Figur 5: eine weitere Abbildung einer mit dem erfindungsgemäßen Verfahren hergestellten Mikrostruktur.

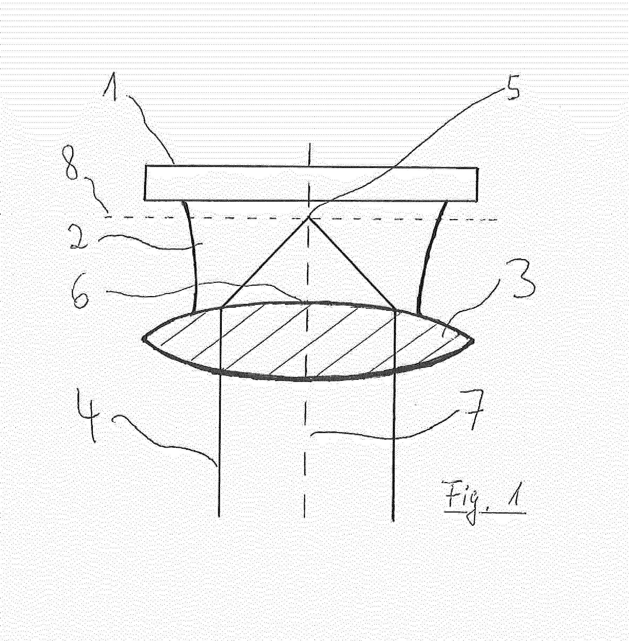

Figur 1 ist eine schematische Darstellung des Kerns der vorliegenden Erfindung: Auf einem Substrat 1 befindet sich eine flüssige photosensitive Substanz 2, die hier aus einem aus der Lithographietechnik bekannten flüssigen Photolacksystem mit einem Brechungsindex zwischen n~1.3 und n~1.7 besteht. Eine (nicht dargestellte) Lichtquelle, hier ein gepulster Laser im Nahinfrarotbereich, wird über ein optisches Abbildungssystem, beispielsweise ein Mikroskop, mit einem Objektiv 3 in die photosensitive Substanz 2 abgebildet, hier angedeutet durch einen Lichtstrahl 4, und in einem Fokus 5 in einer Bildebene 8 fokussiert, um im Bereich des Fokus 5 die Veränderung der Eigenschaften der photosensitiven Substanz 2 hervorzurufen. Der Lichtstrahl 4 tritt aus einer Oberfläche 6 einer Objektivlinse des Objektivs 3 aus, wobei erfindungsgemäß diese Oberfläche 6 in die photosensitive Substanz 2 eingetaucht ist, um etwaige dazwischenliegende Grenzflächen zu vermeiden.

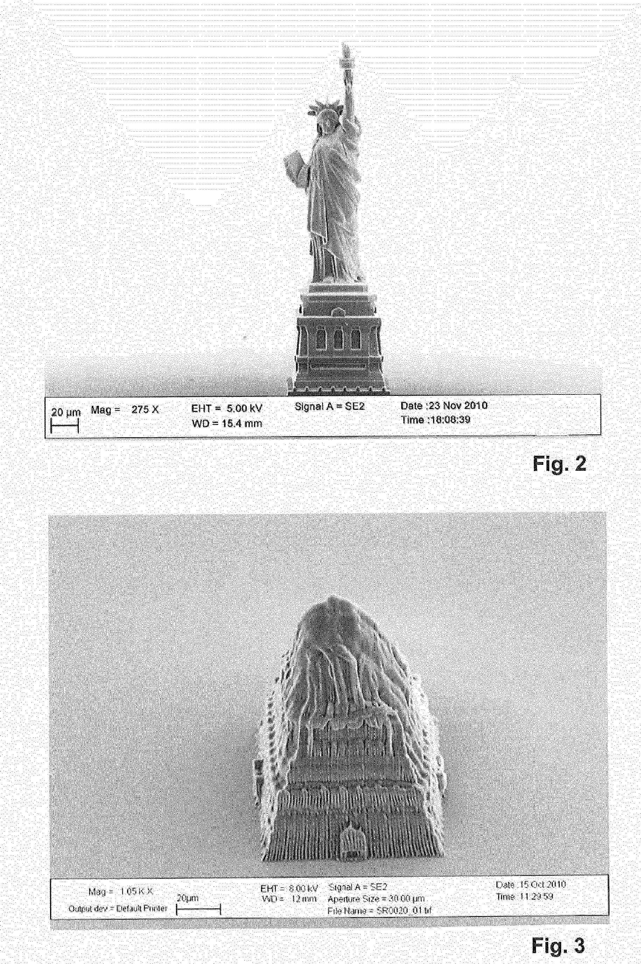

Das Objektiv 3 ist ein Immersionsobjektiv; solche Objektive werden typischerweise für die Brechzahlen von Ölen (n~1.5 - 1.7), Glyzerin (n~1.47) oder Wasser (n~1.3) hergestellt. Passt man in dieser Konfiguration das Objektiv an den Brechungsindex des Photolacks 2 an, so kann man prinzipiell die Bildebene 8 entlang der optischen Achse 7 verschieben und mit konstanten Aberrationen abbilden und strukturieren. Die Abbildung kann insbesondere ein Gauss'scher Fokus sein. Im normalen Fall eines kleinen Unterschieds zwischen dem Brechungsindex, für den das Objektiv 3 ideal funktioniert, und dem Brechungsindex der photosensitiven Substanz 2, kann zwar nicht ohne Aberrationsfehler strukturiert werden, jedoch ist dieser Fehler über die gesamte Schreibtiefe entlang einer optischen Achse 7 konstant, was selbst bei einem nicht perfekt angepassten System zu erheblichen Verbesserungen der Schreibqualität gegenüber dem Stand der Technik führt. Dies wird anhand der nachfolgend beschriebenen Figuren 2 und 3 deutlich.

Figur 2 zeigt die Abbildung einer dreidimensionalen Struktur, die in einer Anordnung gemäß Figur 1 durch Schreiben in IP-L und nachfolgendem Entwickeln der photosensitiven Substanz entstanden ist. Hierbei wurde ein Ölobjektiv für den Brechungsindex n~1.52 und ein Photolack mit dem Brechungsindex n~1.48 verwendet. Die Vorlage war, wie gut zu erkennen ist, die New Yorker Freiheitsstatue, die in einer Gesamtgröße von ca. 300 μm in die photosensitive Substanz geschrieben worden ist.

Auch bei der Struktur, die in Figur 3 abgebildet ist, war die Vorlage die Freiheitsstatue in einer Gesamthöhe von ca. 300 μm; diese konnte jedoch, da ein Verfahren nach dem Stand der Technik verwendet wurde, nicht mit der erforderlichen Genauigkeit in die photosensitive Substanz abgebildet werden.

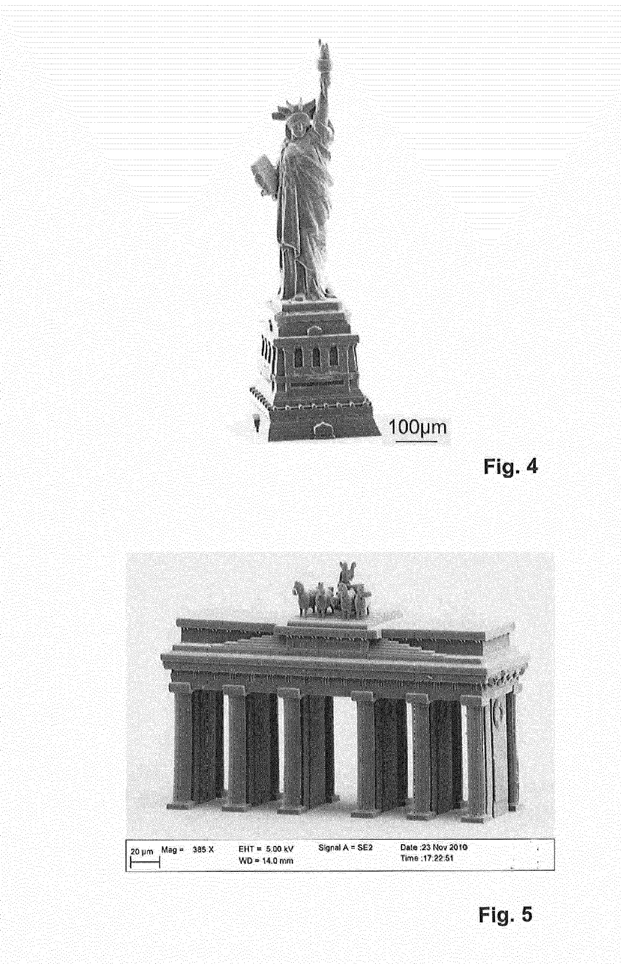

Figur 4 zeigt wiederum die Abbildung einer dreidimensionalen Struktur, die in einer erfindungsgemäß ausgestalteten Anordnung gemäß Figur 1 entstanden ist. Wie bereits in Figur 2, ist auch hier die New Yorker Freiheitsstatue als dreidimensionale Struktur belichtet worden. Allerdings wurde hier, wie der Größenmaßstab in Figur 4 zeigt, eine wesentlich größere Struktur geschrieben: Die Freiheitsstatue ist in gegenüber Figur 2 unverändert hoher Auflösung und dementsprechend hoher Detailtreue sehr viel größer; ihre Gesamthöhe beträgt etwa 1 mm. An diesem Beispiel, das in Figur 4 dargestellt ist, wird verdeutlicht, dass mit der vorliegenden Erfindung dreidimensionale Strukturen in die photosensitive Substanz geschrieben werden können, deren Ausdehnung in Richtung der optischen Achse größer ist als der Arbeitsabstand des zum Schreiben bzw. Belichten verwendeten Objektivs. Und dies, wie man sieht, mit höchster räumlicher Auflösung.

Figur 5 zeigt schließlich ein weiteres Beispiel für eine photolithographisch erzeugte dreidimensionale Struktur unter Verwendung des erfindungsgemäßen Verfahrens, wobei diese Struktur eine Gesamthöhe von ca. 200 μm sowie eine trotz dieser Gesamthöhe bislang unerreichbare Detailtreue in der Ortsauflösung besitzt.

## Patentansprüche

1. Verfahren zum ortsaufgelösten Einbringen eines Intensitätsmusters aus elektromagnetischer Strahlung mittels eines optischen Abbildungssystems in eine photosensitive Substanz mit durch Photoneneinstrahlung veränderbaren Eigenschaften, die einen ersten, flüssigen und mindestens einen zweiten Zustand umfassen,
wobei die elektromagnetische Strahlung (4) über das optische Abbildungssystem (3) in die photosensitive Substanz (2) geleitet und dort auf vorbestimmte Ortskoordinaten abgebildet wird, um an diesen Ortskoordinaten oder in diese umgebenden Bereichen eine Veränderung der Substanzeigenschaften zu erzeugen,
**dadurch gekennzeichnet,**
**dass** eine Oberfläche (6) einer Objektivlinse des optischen Abbildungssystems (3), durch die die elektromagnetische Strahlung (4) aus diesem austritt,
in die flüssige photosensitive Substanz (2) eingetaucht wird.

2. Verfahren nach Anspruch 1
**dadurch gekennzeichnet,**
**dass** mit dem abgebildeten Intensitätsmuster der elektromagnetischen Strahlung (4) ein-, zwei- und/oder dreidimensionale Strukturen in die photosensitive Substanz (2) geschrieben werden.

3. Verfahren nach Anspruch 2,
**dadurch gekennzeichnet,**
**dass** die ein-, zwei- und/oder dreidimensionalen Strukturen mit mehreren abgebildeten Intensitätsmustern sequentiell oder gleichzeitig geschrieben werden und hierfür ein oder mehrere optische Abbildungssysteme verwendet werden.

4. Verfahren nach mindestens einem der Ansprüche 1 bis 3,
**dadurch gekennzeichnet,**
**dass** die flüssige photosensitive Substanz (2) auf einen als Substrat (1) verwendeten Festkörper aufgebracht und dann das optische Abbildungssystem (3) in die flüssige photosensitive Substanz (2) eingetaucht wird.

5. Verfahren nach Anspruch 4,
**dadurch gekennzeichnet,**
**dass** ein transparenter, scheiben- oder plattenförmiger Festkörper als Substrat (1) verwendet und beidseitig eine flüssige photosensitive Substanz (2) auf das Substrat (1) aufgebracht wird.

6. Verfahren nach mindestens einem der Ansprüche 1 bis 5,
**dadurch gekennzeichnet,**
**dass** als Quelle für die elektromagnetische Strahlung (4) ein Laser, insbesondere ein Dauerstrichlaser oder gepulster Laser im elektromagnetischen Spektrum von UV, sichtbarem Licht oder Nahinfrarot verwendet wird.

7. Verfahren nach mindestens einem der Ansprüche 1 bis 6,
**dadurch gekennzeichnet,**
**dass** das Abbilden des Intensitätsmusters durch Fokussieren der elektromagnetischen Strahlung auf die vorbestimmten Ortskoordinaten erfolgt.

8. Verfahren nach mindestens einem der Ansprüche 1 bis 7,
**dadurch gekennzeichnet,**
**dass** die flüssige photosensitive Substanz (2) durch Photoneneinstrahlung auf physikalischem, thermischem und/oder chemischem Wege lokal verändert wird.

9. Verfahren nach mindestens einem der Ansprüche 1 bis 8;
**dadurch gekennzeichnet,**
**dass** die Veränderung der Eigenschaften der photosensitiven Substanz (2) durch einen Einphotonenprozess oder einen Mehrphotonenprozess initiiert und/oder abgeregt wird.

10. Anwendung eines Verfahrens nach mindestens einem der Ansprüche 1 bis 9
zum Erzeugen mikro- oder nanoskaliger Strukturen.

11. Anwendung nach Anspruch 10,
**dadurch gekennzeichnet,**
**dass** die durch Photoneneinstrahlung veränderten Punkte oder Bereiche der photosensitiven Substanz (2) anschließend durch einen selektiven Entwicklungsprozess freigelegt oder entfernt werden.

12. Vorrichtung zum ortsaufgelösten Einbringen eines Intensitätsmusters aus elektromagnetischer Strahlung in eine photosensitive Substanz (2) mit durch Photoneneinstrahlung veränderbaren Eigenschaften, umfassend eine photosensitive Substanz (2), deren Eigenschaften durch Photoneneinstrahlung zwischen einem ersten, flüssigen und mindestens einem zweiten Zustand veränderbar sind, sowie eine Strahlungsquelle und ein optisches Abbildungssystem (3) zum Einleiten einer von der Strahlungsquelle stammenden elektromagnetischen Strahlung (4) in die photosensitive Substanz (2) und zum Abbilden der elektromagnetischen Strahlung (4) in der photosensitiven Substanz (2) auf vorbestimmte Ortskoordinaten (5), um an diesen Ortskoordinaten oder in diese umgebenden Bereichen eine Veränderung der Substanzeigenschaften zu erzeugen,
**dadurch gekennzeichnet,**
**dass** die Vorrichtung so ausgestaltet ist, dass eine Oberfläche (6) einer Objektivlinse des optischen Abbildungssystems (3), durch die die elektromagnetische Strahlung (4) aus diesem austritt, zum Einbringen der elektromagnetischen Strahlung (4) in die photosensitive Substanz (2) in diese eingetaucht wird.

13. Vorrichtung nach Anspruch 12,
**dadurch gekennzeichnet,**
**dass** mehrere optische Abbildungssysteme (3) vorhanden sind, um mehrere Intensitätsmuster (4) in die photosensitive Substanz (2) abzubilden.

14. Vorrichtung nach einem der Ansprüche 12 oder 13,
**dadurch gekennzeichnet,**
**dass** die photosensitive Substanz (2) auf einem als Substrat (1) verwendeten Festkörper aufgebracht ist.

15. Vorrichtung nach Anspruch 14,
**dadurch gekennzeichnet,**
**dass** die photosensitive Substanz (2) beidseitig auf einem als Substrat (1) verwendeten, scheiben- oder plattenförmigen, transparenten Festkörper aufgebracht ist.

16. Vorrichtung nach mindestens einem der Ansprüche 13 bis 15,
**dadurch gekennzeichnet,**
**dass** die Strahlungsquelle für die elektromagnetische Strahlung ein Laser, insbesondere ein Dauerstrichlaser oder gepulster Laser im elektromagnetischen Spektrum von UV, sichtbarem Licht oder Nah-Infrarot ist.

17. Verwendung einer Vorrichtung nach mindestens einem der Ansprüche 12 bis 16 zum Erzeugen mikro- oder nanoskaliger Strukturen.
